# EUROPEAN PATENT SPECIFICATION

(11) **EP 0 646 659 B1**
(45) Date of publication and mention of the grant of the patent: **11.03.1998**
(21) Application number: 94202794.7
(22) Date of filing: 27.09.1994
(51) Int. Cl.: C23C 14/02, C03C 17/36

(54) **Production of carriers for surface plasmon resonance**
Herstellung von Träger für Oberflächenplasmaresonanz
Fabrication de supports pour la résonance de plasmone en surface

(30) Priority: 01.10.1993 GB 9320305
(43) Date of publication of application: 05.04.1995
(73) Proprietor: Johnson & Johnson Clinical Diagnostics, Inc., Rochester New York 14650 (US)
(72) Inventor: Sunderland, Robert Frank, c/o Kodak Limited, Harrow, Middlesex HA1 4TY (GB)
(74) Representative: Mercer, Christopher Paul

(56) References cited:
- EP-A- 0 111 957
- BE-C- 550 365
- FR-A- 956 638
- FR-A- 2 106 431
- GB-A- 1 115 911
- US-A- 3 978 273
- US-A- 5 151 956
- OPTICS AND SPECTROSCOPY, vol.22, no.6, June 1967 pages 507 - 509 E.F.IDCZAK 'optical properties of double metallic films'
- CHEMICAL ABSTRACTS, vol. 93, no. 12, 22 September 1980, Columbus, Ohio, US; abstract no. 119087u, YOSHIDA HIDEO 'coating of selective absorption film on glass substrates' page 267 ;column 93 ;
- CHEMICAL ABSTRACTS, vol. 96, no. 8, 22 February 1982, Columbus, Ohio, US; abstract no. 56765c, ASAHI GLASS 'infrared -reflecting glasses' page 299 ;column 96 ;

## Description

This invention relates to a process for the production of carriers for surface plasmon resonance (SPR).

Surface plasmon resonance or (SPR) is a technique which can be used in the analysis of antibodies which are deposited on surfaces which have been coated with thin films of metal, in particular thin films of silver. SPR based sensors are discussed in a paper by I Faulkner, W R Flavell, J Davies, R F Sunderland and C S Nunnerly :"SPR-based sensors studied by electron energy loss spectroscopy and attenuated total reflection" - to be published in J Electron Spectroscopy, 1993. The manner in which a coating is applied to a surface has important consequences for the subsequent properties of that surface in terms of SPR and control of the coating process is important. At present coating is generally performed by spattering but control is not good. It is important that the films are formed from uniform layers of metal in order to get reproducible SPR. On account of this improved methods for the production of films for SPR are desirable.

According to the present invention we provide a process for the production of a carrier for SPR analysis as defined in the accompanying claims.

The lower preparatory layer is formed from metals comprising a major proportion of nickel. Other metals suitably present include metals which have previously been used in preparation of layers of this type such as titanium and/or chromium. Preferably the lower preparatory layer is formed substantially entirely from nickel.

In operation of the process of the invention the surface, which is suitably a glass surface, is preferably subjected to an appropriate pre-treatment before the metal film is laid down upon it. A suitable pre-treatment comprises the steps of cleaning, followed by treatment by reactive glow discharge. The lower preparatory layer of the metal film is then deposited followed by the silver layer. Preferably after the silver layer is deposited it is annealed effectively in order to bake the metallic film, thereby orienting it and enhancing its chemical properties. The preparatory metallic layer is preferably thin.

Preferably the surface is a glass surface. Any suitable glass surface may be used but a preferred surface has a silicon dioxide surface layer. Particularly suitable types of glass are "PERMABLOC"^{(TM)} and the earlier product "PERMASHEET"^{(TM)} glass, both manufactured by Pilkington Glass of St. Helens, England. These have consistent top layers of silicon dioxide.

In the pre-treatment the glass can be cleaned by any suitable means. Preferred treatments include treating with a freon and/or by ultrasonic treatment and thereafter with a vapour bath or blow drying.

After cleaning the glass is suitably subjected to treatment with an oxygen-containing gas. Any suitable treatment may be used which will cause oxygen ions to enter the surface to an extent sufficient to sensitise it. Preferably the surface is subjected to a reactive glow discharge treatment which suitably uses a mixture of oxygen and an inert gas in particular argon. The surface can be put into a vacuum system in a clean room environment. It may then be subjected to reactive glow discharge using a mixture of oxygen and a rare gas containing suitably 5% to 15% oxygen. A preferred treatment uses a mixture of argon (90%) and oxygen (10%). The treatment time is suitably 1 to 5 minutes with 2 minutes being preferred. Prior to this procedure the chamber is suitably pumped to a high vacuum. The organic vapour is suitably low or negligible.

When reactive glow discharge treatment has been completed the preparatory metallic layer of or containing nickel is deposited on the glass to form a base for the silver layer. It is suitably deposited using an electron beam source. Suitably it has a thickness in the range 20Å to 40Å, preferably 20Å to 30Å and especially 25Å to 30Å.

The silver layer is deposited on the preparatory metallic layer, suitably soon and preferably immediately after the latter has been formed. Suitably the silver layer has a thickness in the range 500Å to 600Å, preferably 520Å. This has been found to give the optimum SPR response. The deposit of the silver layer is suitably made at a low rate, being used to analyse the binding of antibodies. It is less important for analysing the binding of compounds such as dextran. The annealing step is preferably carried out immediately after the silver layer has been deposited but the presence of one or more intermediate steps is not precluded.

The invention is illustrated by the following example:-

### Example

A sheet of "PERMASHEET"^{(TM)} glass obtained from Pilkingtons Glass, St Helens, England was cleaned by ultrasonic treatment with a freon liquid, followed by freon vapour drying to eliminate streaking marks.

The cleaned sheet was then put into a vacuum system in a clean room environment and evacuated to approximtely 10⁻⁷m bar in an oil-free environment. It was then subjected to reactive glow discharge using a gaseous mixture comprising 90% argon and 10% oxygen for a 2 minute period. This was done by admitting a small amount of the gaseous mixture to the system and pumping at a pressure of 20 to 60 microns while applying a voltage of 300V to an electrode for 2 minutes. As a result of this treatment oxygen ions have sufficient energy to enter the surface of the glass and sensitise it. The equipment used was a Temescale 2550 coating system using a Telemark 4 crucible e-gun evaporator with Sycon controller.

After reactive glow discharge treatment the system was repumped to approximately 10⁻⁷m bar. Then a thin layer of nickel from a 99.9% pure ingot produced by Materials Research Corporation (MCR) was laid down upon the glass surface using an electron beam source. A typical beam current was 60mA at 10 KeV energy. The layer was 25Å to 30Å in thickness. Deposition time was 25 to 30 seconds at 1Å per second.

Immediately after the layer of nickel had been laid down a layer of silver from a 99.9% pure ingot from MCR was laid upon it using the same technique. A typical beam current was 50mÅ at 10 KeV. The silver layer was 520Å in thickness. Deposition time was 8.5 minutes at 1Å per second.

After deposit of the silver layer annealing was effected by placing the coated glass surface in a chamber and subjecting it to infra red heating at 150°C for 4 hours.

The silver coated glass surface produced had a very suitable SPR response.

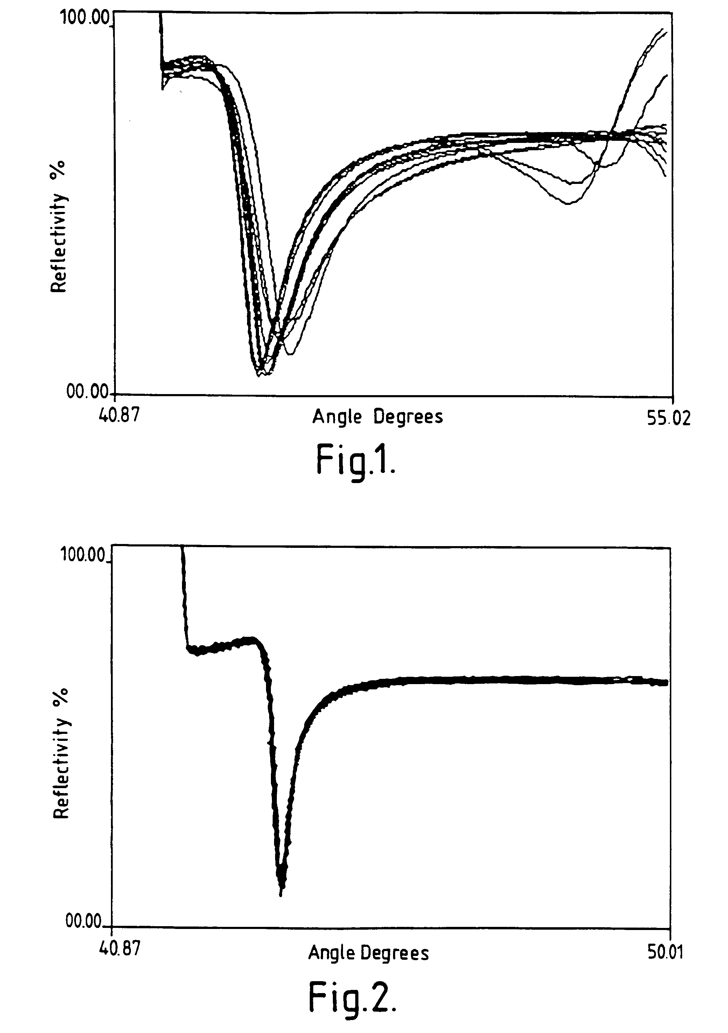

This is illustrated by Figures 1 and 2 of the accompanying drawings wherein:-
Figure 1 is a graph of percentage light transmitted against angular position for a conventional commercially available SPR system; and
Figure 2 is a graph of percentage light transmitted against angular position for the system of the Example.

The Figures show that the characteristics produced by the Example are superior, giving a sharper, more distinct minimum in the curve.

Figure 1 relates to an air SPR of typically commercially available slides of approximately 410Å gold (measured by optical density) with assay material removed from the gold surface.

Figure 2 relates to air SPR and to slides prepared by the process of the invention of approximately 560Å silver with underlay measured by optical density.

## Claims

1. A process for the production of a carrier for surface plasmon resonance analysis (SPR) in which a metallic film comprising a lower preparatory layer of a first metal and an upper layer of silver is deposited on a surface characterised in that the lower preparatory layer comprises a major proportion of nickel.

2. A process according to claim 1 characterised in that after the silver layer has been deposited the film is subjected to an annealing step during which it is heated for a period in the range 1.5 to 4 hours.

3. A process according to claim 1 or claim 2 characterised in that during the annealing step the film is heated to a temperature in the range 125° to 175°C.

4. A process according to any one of the preceding claims characterised in that the surface is glass coated with a silicon dioxide surface layer.

5. A process according to any one of the preceding claims characterised in that the silver layer has a thickness in the range 500Å to 600Å.

6. A process according to any one of the preceding claims characterised in that a preparatory metallic layer is formed substantially entirely of nickel.

7. A process according to any one of claims 1 to 5 characterised in that the preparatory metallic layer comprises titanium and/or chromium in addition to nickel.

8. A process according to any one of the preceding claims characterised in that the preparatory metallic layer has a thickness in the range 20Å to 40Å.

9. A process according to any one of the preceding claims characterised in that before the lower preparatory layer is deposited the surface is subjected to a pre-treatment comprising the steps of cleaning and treatment by reactive glow discharge.

10. A process according to claim 8 characterised in that the reactive glow discharge treatment uses a mixture of oxygen and argon containing 5% to 15% oxygen.

## Patentansprüche

1. Verfahren zur Herstellung eines Trägers für die Oberflächen-Plasmonresonanz-Analyse (SPR), bei dem ein eine Schicht von Silber enthaltender Metallfilm auf einer Oberfläche abgeschieden wird, dadurch gekennzeichnet, daß nach dem Abscheiden der Silberschicht der Film einer Temperungsstufe unterworfen wird, in der er auf eine zur Temperung ausreichende Temperatur erhitzt wird.

2. Verfahren nach Anspruch 1, dadurch gekennzeichnet, daß der Film während der Temperungsstufe während einer Dauer im Bereich von 1,5 bis 5 Stunden erhitzt wird.

3. Verfahren nach Anspruch 1 oder Anspruch 2, dadurch gekennzeichnet, daß der Film während der Temperungsstufe auf eine Temperatur im Bereich von 125 bis 175°C erhitzt wird.

4. Verfahren nach einem der vorhergehenden Patentansprüche, dadurch gekennzeichnet, daß die Oberfläche mit einer Siliciumdioxid-Oberflächenschicht beschichtetes Glas ist.

5. Verfahren nach einem der vorhergehenden Patentansprüche, dadurch gekennzeichnet, daß die Silberschicht eine Dicke im Bereich von 500 Å bis 600 Å hat.

6. Verfahren nach einem der vorhergehenden Patentansprüche, dadurch gekennzeichnet, daß vor dem Abscheiden der Silberschicht eine vorbereitende Metallschicht abgeschieden wird, die einen überwiegenden Anteil an Titan, Nickel und/oder Chrom enthält.

7. Verfahren nach Anspruch 6, dadurch gekennzeichnet, daß die vorbereitende Metallschicht im wesentlichen aus Nickel ausgebildet wird.

8. Verfahren nach Anspruch 6 oder Anspruch 7, dadurch gekennzeichnet, daß die vorbereitende Metallschicht eine Dicke im Bereich von 20 Å bis 40 Å hat.

9. Verfahren nach einem der vorhergehenden Patentansprüche, dadurch gekennzeichnet, daß vor dem Abscheiden der Silberschicht die Oberfläche einer Vorbehandlung unterworfen wird, welche die Stufen des Reinigens, der Behandlung durch reaktive Glimmentladung und danach der Abscheidung einer vorbereitenden Metallschicht umfaßt.

10. Verfahren nach Anspruch 8, dadurch gekennzeichnet, daß für die Behandlung durch reaktive Glimmentladung ein Gemisch aus Sauerstoff und Argon mit einem Sauerstoffgehalt von 5 % bis 15 % verwendet wird.

## Revendications

1. Procédé de fabrication d'un support pour l'analyse de résonance de plasmone en surface (SPR) dans lequel un film métallique, comprenant une couche préparatoire inférieure constituée d'un premier métal et une couche supérieure d'argent, est déposé sur une surface, caractérisé en ce que la couche préparatoire inférieure se compose principalement de nickel.

2. Procédé selon la revendication 1, caractérisé en ce que, une fois que la couche d'argent a été déposée, le film est soumis à une étape de recuit au cours de laquelle il est chauffé pendant une période allant de 1,5 à 4 heures.

3. Procédé selon la revendication 1 ou la revendication 2, caractérisé en ce que, au cours de l'étape de recuit, le film est chauffé à une température comprise entre 125°C et 175°C.

4. Procédé selon l'une quelconque des revendications précédentes, caractérisé en ce que la surface est enrobée de verre avec une couche superficielle de dioxyde de silicium.

5. Procédé selon l'une quelconque des revendications précédentes, caractérisé en ce que la couche d'argent est d'une épaisseur comprise entre 500 Å et 600 Å.

6. Procédé selon l'une quelconque des revendications précédentes, caractérisé en ce qu'une couche métallique préparatoire est formée sensiblement intégralement de nickel.

7. Procédé selon l'une quelconque des revendications 1 à 5, caractérisé en ce que la couche métallique préparatoire comprend du titane et/ou du chrome en plus du nickel.

8. Procédé selon l'une quelconque des revendications précédentes, caractérisé en ce que la couche métallique préparatoire est d'une épaisseur comprise entre 20 Å et 40 Å.

9. Procédé selon l'une quelconque des revendications précédentes, caractérisé en ce que, avant le dépôt de la couche préparatoire inférieure, la surface est soumise à un pré-traitement comprenant les étapes de nettoyage et de traitement par décharge lumineuse réactive.

10. Procédé selon la revendication 8, caractérisé en ce que le traitement par décharge lumineuse réactive utilise un mélange d'oxygène et d'argon contenant de 5 à 15 % d'oxygène.
